# EUROPÄISCHE PATENTSCHRIFT

(11) **EP 0 837 801 B1**
(45) Veröffentlichungstag und Bekanntmachung des Hinweises auf die Patenterteilung: **30.01.2002**
(21) Anmeldenummer: 97920596.0
(22) Anmeldetag: 12.04.1997
(51) Int. Cl.: B60T 8/00

(54) **EINRICHTUNG ZUR ERKENNUNG VON ELEKTROMAGNETISCHEN EINSTREUUNGEN**
DEVICE FOR THE RECOGNITION OF ELECTROMAGNETIC INTERFERENCE
DISPOSITIF POUR LA RECONNAISSANCE D'INTERFERENCES ELECTROMAGNETIQUES

(30) Priorität: 18.04.1996 DE 19615203
(43) Veröffentlichungstag der Anmeldung: 29.04.1998
(73) Patentinhaber: ROBERT BOSCH GMBH, 70442 Stuttgart (DE)
(72) Erfinder: DONATH, Ralf, D-71254 Ditzingen (DE)
(86) Internationale Anmeldenummer: DE9700746
(87) Internationale Veröffentlichungsnummer: WO9739929

(56) Entgegenhaltungen:
- EP-A- 0 070 961
- WO-A-82/02862
- FR-A- 2 147 830

## Beschreibung

### Stand der Technik

Bei Fahrzeugen, die mit einem Antiblockierregelsystem (ABS) oder einer Antriebsschlupfregelung (ASR), (ABSR) oder einer Fahrdynamikregelung (FDR) ausgerüstet sind, werden üblicherweise vier Drehzahlfühler eingesetzt, die den einzelnen Rädern zugeordnet sind. Die Drehzahlfühler sind üblicherweise induktive Aufnehmer, deren Ausgangssignal einen sinusförmigen Verlauf aufweist. Nach der Aufbereitung wird eine rechteckförmige Impulsfolge erhalten, aus dem zeitlichen Abstand der einzelnen Impulse bzw. einzelner Impulsflanken läßt sich die Drehzahl des betreffenden Rades ermitteln.

Die von den Drehzahlfühlern erhaltenen Informationen werden einem Regler, beispielsweise dem ABS-Regler zugeführt, der anhand der ermittelten Raddrehzahlen die erforderlichen Regelmaßnahmen durchführt. Da falsche Ausgangssignale der Drehzahlfühler die Regelung beeinträchtigen, sollte sichergestellt werden, daß die von den Drehzahlfühlern gelieferten Signale tatsächlich von der Drehzahl des Rades herrühren und nicht von möglicherweise eingestreuten Signalen. Besonders empfindlich reagieren induktive Drehzahlfühler auf äußere Einflüsse, beispielsweise Feldänderungen durch öffentliche Stromnetze, die bekannter maßen Frequenzen von 50 oder 60 Hz aufweisen. Durch solche Stromnetze können in den Drehzahlfühlern Signale erzeugt werden, die nicht der zur erfassenden Regelgröße, also nicht der zu erfassenden Drehzahl entsprechen. Solche Signale werden als Einstreuungen bezeichnet.

Elektromagnetische Einstreuungen treten nicht nur bei Drehzahlfühlern auf, sondern allgemein bei Induktivsensoren, beispielsweise bei Sensoren zur Messung von Entfernungen, Winkeländerungen beispielsweise bei der Motorsteuerung usw. Besonders beim Einsatz in Fahrzeugen sollten Maßnahmen getroffen werden, die induktive Einstreuungen erkennen und es ausschließen, daß Signale, die durch induktive Einstreuung entstehen, irrtümlicherweise als Nutzsignale verwendet werden.

Ein Antiblockierregelsystem, bei dem eine Erkennung von Einstreuungen auf induktive Aufnehmer durch elektromagnetische Felder des Stromnetzes durchgeführt wird und bei der das Antiblockierregelsystem selbst Maßnahmen ergreift, die sicherstellen, daß durch die Einstreuungen keine unerwünschten Regelzustände auftreten, ist aus der Patentanmeldung DE-P 1 95 032 71.3 bekannt. Dieses Dokument offenbart der Oberbegriff des Anspruchs 1. Bei diesem bekannten Antiblockierregelsystem wird die Fahrzeugreferenzgeschwindigkeit, die für die Regelung benötigt wird, aus den Ausgangssignalen von Raddrehzahlfühlern ermittelt. Sobald erkannt wird, daß die Frequenz der auszuwertenden Signale in einem kritischen Bereich von etwa 50 bis 60 Hz liegt, werden zusätzliche Maßnahmen getroffen, die verhindern, daß Einstreuungen zu Fehlern bei der Berechnung der Referenzgeschwindigkeit führen.

Die durch elektromagnetische Einstreuung von Stromnetzen entstehende Signale treten ungünstigerweise besonders dann in Erscheinung, wenn vom Drehzahlfühler überhaupt kein Signal erzeugt werden sollte, d. h. wenn das Fahrzeug steht oder sich in einem Geschwindigkeitsbereich unter 2,75 km/h befindet. Die eingestreuten Signale mit Frequenzen von 50 oder 60 Hz verursachen besonders bei derzeit eingesetzten Bremsreglern bei Geschwindigkeiten von etwa 5 bis 15 km/h einige Probleme. Welche Geschwindigkeit besonders kritisch ist, hängt von verschiedenen Parametern, beispielsweise vom Radumfang, der Zähnezahl der vom Aufnehmer abgetasteten Scheibe usw. ab. Die Amplitude der elektromagnetischen Einstreuungen liegt üblicherweise unter 150 mV. Die Signale der Drehzahlfühler müßten bei Frequenzen von 50 bis 60 Hz im Volt-Bereich liegen. Ausgehend von diesem ansich bekannten Sachverhalt besteht die Aufgabe der Erfindung darin, elektromagnetische Einstreuungen im Bereich von 50 bis 60 Hz, die beispielsweise vom öffentlichen Stromnetz verursacht werden, zuverlässig zu erkennen und die zugehörigen Informationen vor der Zuführung zu einer nachfolgenden Regelung sicher zu unterdrücken oder zu kompensieren. Gelöst wird die Aufgabe durch eine Einrichtung zur Erkennung von elektromagnetischen Einstreuungen mit den Merkmalen des Anspruchs 1.

### Vorteile der Erfindung

Die erfindungsgemäße Einrichtung zur Erkennung von elektromagnetischen Einstreuungen hat den Vorteil, daß die Einstreuungen besonders zuverlässig von den Nutzsignalen unterschieden werden können. Damit wird gleichzeitig sichergestellt, daß in einer nachfolgenden Verarbeitungseinrichtung, beispielsweise einem nachfolgenden Regler für ABS, ABSR oder FDR keine Fehlinformationen verarbeitet werden. Erzielt wird dieser Vorteil indem drei unabhängige Überprüfungen stattfinden. Bei der ersten Prüfung wird als Grundvoraussetzung für die Einstreuungserkennung die Periodendauer der von den Aufnehmern gelieferten Signale gemessen. Wenn diese Periodendauer in einem Bereich liegt, der sich mit der Periodendauer der erwarteten Einstreuung einschließlich einer gewissen Toleranz deckt, wird erkannt, daß die Möglichkeit besteht, daß es sich bei dem registrierten Signal um eine Einstreuung handelt. Da es sich aber auch um ein reelles Signal handeln kann, schließen sich an diese erste Überprüfung weitere Prüfungen an. Dabei wird als zweite Prüfung ausgewertet, ob es sich bei den registrierten Signalverläufen um Signalverläufe handelt, wie sie bei Einstreuungen erwartet werden. Dieser Überprüfung liegt die Erkenntnis zugrunde, daß sich Sensorsignale bei geringer Fahrzeuggeschwindigkeit oder bei Fahrzeuggeschwindigkeit gleich 0, also bei Bedingungen, bei denen die Frequenz der Ausgangssignale minimal ist, in charakteristischer Weise ändern, sofern Einstreuungen auftreten. Wird ein solcher charakteristischer Signalverlauf erkannt, handelt es sich bei dem registrierten Signal bereits mit großer Wahrscheinlichkeit um eine Einstreuung. Um jedoch ganz sicher zu sein, daß es sich um eine Einstreuung handelt, wird in einer dritten Prüfung eine Plausibilitätsuntersuchung durchgeführt, bei der das zu überprüfende Signal mit parallel gemessenen anderen Signalen, beispielsweise von einem oder mehreren anderen Raddrehzahlaufnehmern verglichen wird. Erst wenn auch diese dritte Prüfung erkennen läßt, daß es sich bei dem zu untersuchenden Signal um kein reguläres Signal handelt, wird davon ausgegangen, daß es sich um eine Einstreuung handelt und das betreffende Signal wird von der Weiterverarbeitung ausgeschlossen. Danach wird beispielsweise auf ein Ersatzsignal zurückgegriffen oder das eingestreute Signal wird in die plausible Richtung korrigiert.

Weitere Vorteile der Erfindung werden durch die in den Unteransprüchen aufgeführten Maßnahmen erzielt. Als besonders vorteilhaft hat es sich erwiesen, die Einstreuerkennung sowie die sich anschließenden Maßnahmen zur Verhinderung der irrtümlichen Verwertung der durch Einstreuung erzeugten Signale in eigenen Aufbereitungsmitteln durchzuführen, beispielsweise einem separaten Mikroprozessor oder als vorgelagertes Modul im Reglerprozessor. Dies hat gegenüber der bekannten Lösung, nach der die Einstreumaßnahmen erst im Regler selbst getroffen werden, den Vorteil, daß sich beliebige Regler verwenden lassen, denen bereits auf Zuverlässigkeit überprüfte Sensorausgangssignale zugeführt werden.

Weitere Vorteile der Erfindung sind darin zu sehen, daß die Einstreuerkennung unabhängig von der Antriebsart des Fahrzeuges, also unabhängig davon ob Heck-, Front- oder Allradantrieb des Fahrzeuges vorgesehen ist, einsetzbar ist. Die Anzahl der Zähne der Sensorräder ist nicht bedeutsam, d. h. es ist nicht erforderlich, eine Zahl von Zähnen zu wählen, die keine kritischen Signalfrequenzen liefert. In vorteilhafter Weise kann die Geschwindigkeitsaufbereitung einschließlich der erforderlichen Maßnahmen zur Erkennung der Einstreuung und Unterdrückung fehlerhaften Signale als Softwarelösung realisiert werden.

### Zeichnung

Ein Ausführungsbeispiel der Erfindung ist in der Zeichnung dargestellt und wird in der nachfolgenden Beschreibung näher erläutert. Im einzelnen zeigt Figur 1 ein Blockschaltbild einer erfindungsgemäßen Einrichtung zur Erkennung von elektromagnetischen Einstreuungen. In Figur 2a und 2b sind Ausgangssignale sowie aufbereitete Signale von Drehzahlfühlern über der Zeit aufgetragen, wobei in Grafik 1 ein Signalverlauf dargestellt ist, der bei einer Einstreuung ohne Nutzsignal auftritt. In Grafik 2 ist der Signalverlauf bei Vorhandensein eines Nutzsignales sowie einer überlagerten Einstreuung dargestellt. In Figur 3 ist das ablaufende Prüfverfahren als Flußdiagramm dargestellt und in Figur 4a und 4b sind charakteristische Signalverläufe bei Einstreuungen dargestellt, wobei in Figur 4a ein Beispiel für einen Sprung der Frequenz und in Figur 4b ein langsames schrittweises Anwachsen der Frequenz jeweils als Folge von Einstreuungen dargestellt ist.

### Beschreibung

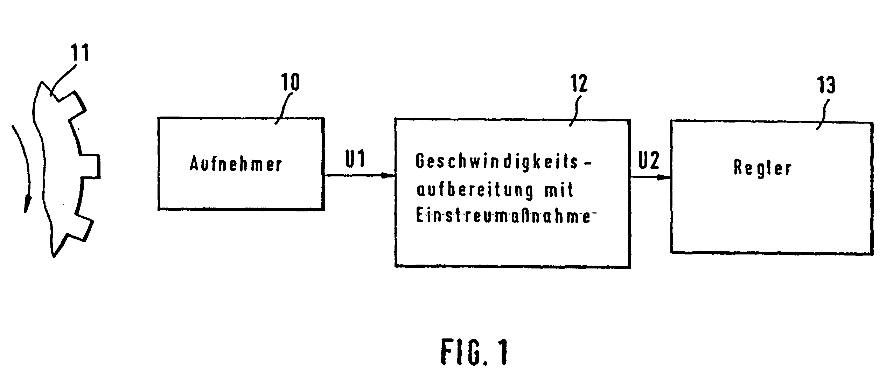

In Figur 1 ist ein Ausführungsbeispiel einer Einrichtung, in der die erfindungsgemäße Einstreuerkennung stattfinden kann, dargestellt. Bei diesem Beispiel wird mit einem Aufnehmer 10, beispielsweise ein Drehzahlfühler ein Zahnrad 11 abgetastet, das beispielsweise mit einer Welle eines Rades verbunden ist und sich synchron mit diesem Rad dreht. Das Ausgangssignal des Aufnehmers 10 ist mit U1 bezeichnet, es wird einer Geschwindigkeitsaufbereitung mit Einstreumaßnahme 12 zugeführt, die beispielsweise als Mikroprozessor ausgestaltet ist. Das Ausgangssignal der Geschwindigkeitsaufbereitung mit Einstreumaßnahme 12 ist als S2 bezeichnet, es wird dem Regler 13 zugeführt, der beispielsweise ein ABS-, ABSR- oder FDR-Regler sein kann. Da das Siganl U2 bereits korrigiert ist, also keine durch Einstreuungen verursachte Signalbestandteile mehr aufweist, müssen im Regler 13 keine weiteren Maßnahmen zur Unterdrückung oder Nichtberücksichtigung von Einstreusignalanteilen getroffen werden.

Bei dem in Figur 1 dargestellten Beispiel ist lediglich ein einziger Aufnehmer 10 angegeben., Bei üblichen Antiblockiersystemen, Antriebsschlupfregelungen oder Fahrdynamikregelungen sind mehrere Aufnehmer 10 und Zahnräder 11 vorhanden, üblicherweise befindet sich an jedem Rad eines Fahrzeuges ein solcher Aufnehmer 10 sowie ein Zahnrad 11. Die in Figur 1 dargestellte Einrichtung beschränkt sich jedoch nicht auf die erwähnten Regelsysteme, sondern kann auf beliebig Sensorsysteme ausgedehnt werden, bei denen Einstreuungen durch elektromagnetische Felder insbesonders mit 50 oder 60 Hz auftreten können.

Das Signal U1 hat beim Ausführungsbeispiel nach Figur 1 einen periodischen Verlauf, wobei die Periode abhängig ist von der Geschwindigkeit des Zahnrades 11 sowie der Zahl der Zähne des Zahnrades. Ohne Einstreuung handelt es sich bei dem Signal U1 üblicherweise um ein recht gleichförmiges Signal. Vor der Weiterverarbeitung wird dieses Signal in ein Rechtecksignal gewandelt, wobei es in üblicher Weise in einem Komperator mit Triggerschwellen verglichen wird und Umschaltungen jeweils an einer oberen Triggerschwelle und an einer unteren Triggerschwelle erfolgen.

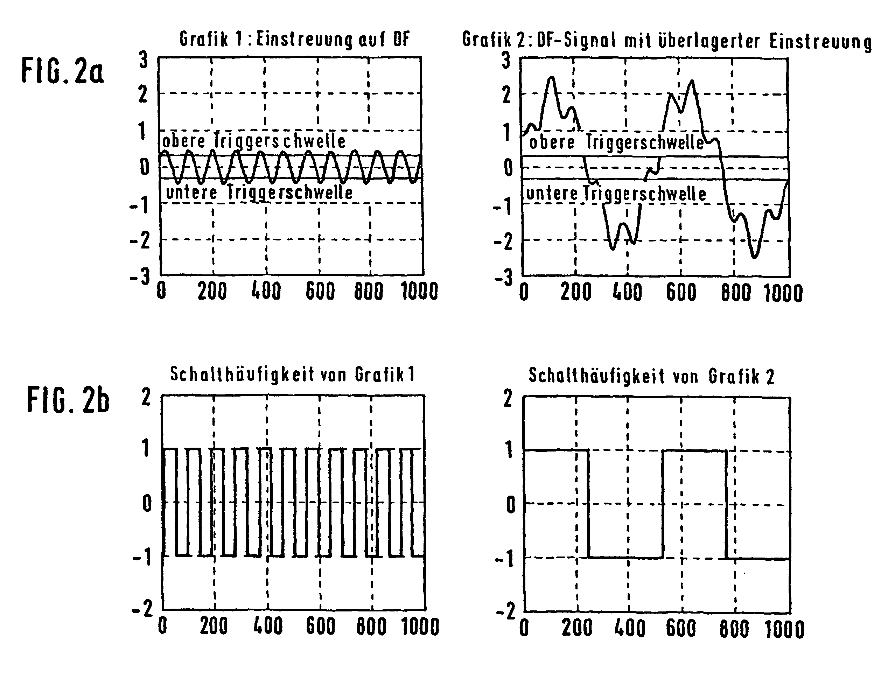

In Figur 2a sind Ausgangssignale U1 eines Aufnehmers 10 über der Zeit aufgetragen, wobei es sich bei den mit Grafik 1 bezeichneten Signalen ausschließlich um Signale handelt, die durch elektromagnetische Einstreuung durch Magnetfelder eines Stromnetzes erzeugt wurden. Bei den unter Grafik 2 dargestellten Signalen ist ein reguläres Drehzahlfühlersignal vorhanden, dem Einstreusignale überlagert sind.

Jeweils bei Überschreiten der oberen Triggerschwelle oder Unterschreiten der unteren Triggerschwelle schaltet ein Komperator, der Bestandteil der Geschwindigkeitsaufbereitung mit Einstreumaßnahme 12 ist und es entsteht jeweils der in Figur 2b dargestellte Rechteckverlauf.

Wenn eine Einstreuung ohne reales Signal vorliegt, schaltet der Komperator an den Triggerschwellen, wobei die Umschaltungen durch die Einstreuung verursacht werden. Mit gängigen Drehzahlfühlern liegt die Spannungsamplitude bei alleiniger Einstreuung im Millivolt-Bereich. Wenn dagegen das Fahrzeug anfährt, wird durch das rotierende Zahnrad 11 im Aufnehmer 10 ein Signal erzeugt, dessen Amplitude im Bereich von einer Geschwindigkeit, die einer Frequenz von 50 Hz bzw. 60 Hz entspricht beträchtlich größer ist und im Volt-Bereich liegt. Die diesem Signal überlagerte Einstreuung hat praktisch keinen Einfluß mehr auf das Schalten des Komparators und daraus kann gefolgert werden, daß die Einstreuung sich nur bei stehendem Fahrzeug oder bei einer sehr niedrigen Geschwindigkeit störend auswirkt. Bei diesen Geschwindigkeiten ist die Frequenz des Signales des Aufnehmers unterhalb von fmin. Bei einem derartigen Geschwindigkeitsbereich liefert der Sensor noch kein sicher nutzbares Signal. Mit den derzeit bei ABS-, ABSR- und FDR-Systemen liegt dieser Bereich bei einer Fahrzeuggeschwindigkeit von etwa 2,5 km/h. Wie später noch näher erläutert wird, kann die erwähnte Folgerung als Plausibilitätsprüfung verwendet werden.

Zur Bestimmung der Radgeschwindigkeit wird die Periodendauer des aufbereiteten Signales ausgewertet. Sind die Störsignale zu diesem Zeitpunkt bereits zuverlässig erkannt und ausgeblendet, ist sichergestellt, daß die ermittelte Geschwindigkeit die tatsächliche Geschwindigkeit ist.

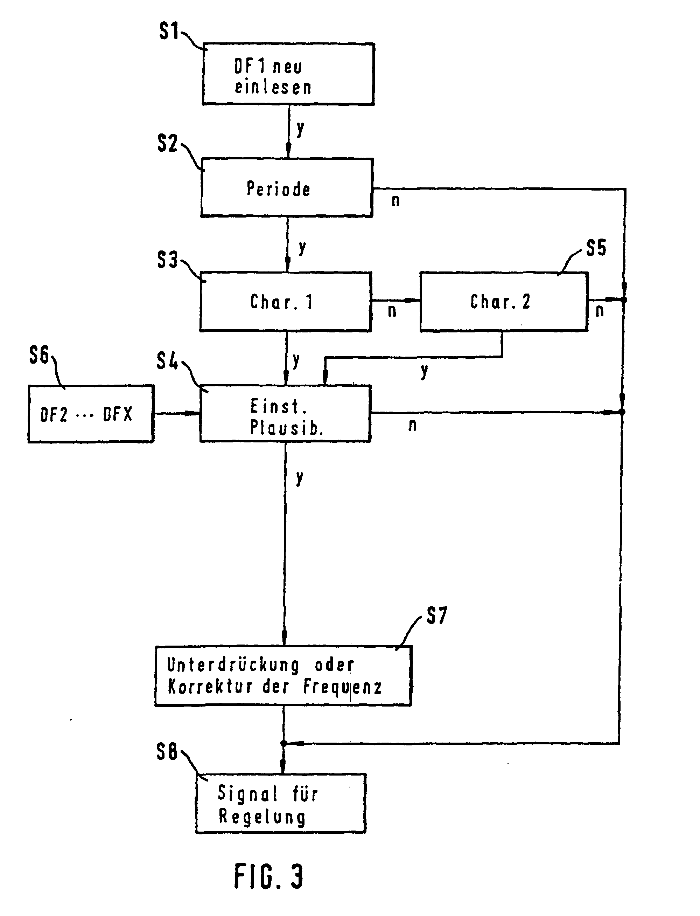

Bei der Überprüfung, ob die registrierten Signale reelle Signale sind, oder ob es sich um Einstreuungen handelt, wird die im folgenden näher beschriebene Vorgehensweise durchgeführt. Die einzelnen Schritte werden dabei anhand des in Figur 3 dargestellten Flußdiagrammes näher erläutert.
Als Ausführungsbeispiel wird ein System gewählt, bei dem bei einem Kraftfahrzeug an jedem Rad oder mindestens an beiden Vorderrädern und am Differenzial der Hinterachse (3 Geber Fahrzeug) ein Induktivsensor zugeordnet ist, der jeweils ein rotierendes Zahnrad abtastet und ein periodisches Ausgangssignal abgibt, das von der Radgeschwindigkeit abhängt. Die Einstreuerkennung selbst wird dabei mit Hilfe eines Mikroprozessors oder Moduls vorgenommen, der oder das vorteilhafterweise nicht Bestandteil eines nachfolgenden Reglers ist. Die drei bzw. vier Drehzahlfühler werden alle auf Einstreuungen überprüft.

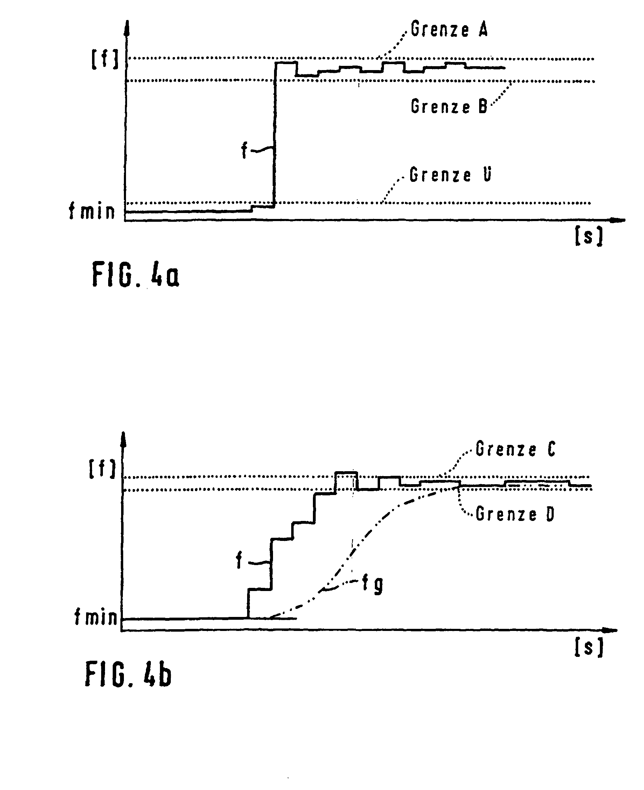

Im erwähnten Mikroprozessor wird in einer Prüfung geprüft, ob die Grundvoraussetzung für das Auftreten der Einstreuproblematik erfüllt ist. Dazu wird die Periodendauer der Sensorsignale gemessen. Wenn sich diese Periodendauer mit der Periodendauer der erwarteten Einstreuung plus minus einer vorgebbaren Toleranz deckt, besteht die Möglichkeit einer Einstreuung. Da dies aber auch ein reales Signal sein kann, schließen sich an die erste Prüfung weitere Prüfungen an, die als erweiterte Signalauswertung aufgefasst werden können. Wie Figur 3 zu entnehmen ist, werden zur Überprüfung der Grundvoraussetzung in einem ersten Schritt S1 Signale eines Raddrehzahlfühlers eingelesen. Im Schritt S2 wird die Periode dieser Signale ermittelt. Entspricht die ermittelte Periodendauer nicht der Periodendauer der erwarteten Einstreuung einschließlich der zu erwartenden Toleranz, wird das Signal als richtig erkannt und einem nachfolgenden Regler, beispielsweise ABS-Regler, als Eingangsgröße bzw. Istgröße zugeführt (S8) und die Einstreuerkennung für das betreffende Signal beendet. Wird dagegen im Schritt S2 erkannt, daß die Periodendauer sich mit der Periodendauer der erwarteten Einstreuung plus minus Toleranz deckt, wird im Schritt S3 eine zweite Prüfung durchgeführt. Bei dieser zweiten Prüfung wird geprüft, ob die betreffenden Signle einen für Einstreuungen charakteristischen Signalverlauf aufweisen. Dieser Vorgehensweise liegt die Erkenntnis zugrunde, daß Einstreusignale beim Fehlen von Nutzsignalen, also bei Radgeschwindigkeiten, die unterhalb eines minimalen wertes liegen charakteristische Verläufe aufweisen. Diese charakteristischen Signalverläufe werden im folgenden anhand der Figuren 4a und 4b näher erläutert. In den Figuren 4a und 4b sind dabei nicht die Geschwindigkeiten, sondern die zugehörigen Frequenzen aufgetragen, könnten aber auch als Geschwindigkeiten aufgetragen werden.

Ein erster möglicher charakteristischer Signalverlauf ist in Figur 4a dargestellt. Dabei ist die Frequenz des Signales über der Zeit aufgetragen. Die Frequenz des Signales beträgt zunächst fmin, dies entspricht der minimalen nutzbaren Frequenz des Sensors. Die Frequenz f springt beim Auftreten von Einstreuungen auf einen Wert, der innerhalb eines sog. Erkennungsbandes A/B liegt mit anfänglich starker Schwankungsbreite. Dieser Signalverlauf wurde anhand einer Vielzahl von Messungen erkannt. Für reale Frequenzverläufe, also für Frequenzverläufe, die von tatsächlichen Nutzsignalen erzeugt werden, ist ein solcher Signalverlauf eher unwahrscheinlich.

In Figur 4b ist ein Frequenzverlauf für Einstreuungen aufgetragen, der einem in der Realität oft auftretenden Verlauf entspricht. Dieser Verlauf entspricht einer ansteigenden Radgeschwindigkeit, die Frequenz liegt zunächst in einem Bereich nahe der minimalen nutzbaren Frequenz des Sensors (fmin). Die Frequenz f steigt dann an und liegt innerhalb einer gewissen Schwankungsbreite. Diese Schwankungsbreite wird durch ein Erkennungsband C/D begrenzt. Wenn die Frequenzänderung tatsächlich durch eine Einstreuung verursacht wird, die beispielsweise konstant 50 Hz aufweist, wird die Schwankungsbreite des durch die Einstreuung erzeugten Signales nach einer gewissen Zeit sehr schmal sein. Bei der weiteren Auswertung dieses Signalverlaufes wird dies berücksichtigt.

Die beiden in Figur 4a und 4b dargestellten Frequenzverläufe werden als charakteristische Signalverläufe bei Einstreuungen zur Einstreuerkennung ausgewertet, d. h. es wird überprüft, ob das aktuelle Drehzahlsignal einen dieser charakteristischen Verläufe aufweist. Die im Verfahren nach Figur 3 als Schritt S3 bezeichnete Sprungerkennung läuft so ab, daß auf Sprung erkannt wird, wenn die Frequenz des Signales von einem Wert, der unterhalb der Grenze U, also nahe bei fmin liegt, direkt in einen Bereich springt, der innerhalb der Grenzen A und B liegt. Die Festlegung der Grenzen A und B erfolgt so, daß die zu erwartenden Einstreufrequenzen sicher innerhalb des Bereiches A /B liegen. Da der in Figur 4a dargestellte Frequenzverlauf eher unwahrscheinlich ist, könnnen die Grenzen A und B so gewählt werden, daß das Erkennungsband A/B relativ breit ist.

Wird erkannt, daß ein Frequenzsprung wie er in Figur 4a dargestellt ist, aufgetreten ist, wird davon ausgegangen, daß es sich mit größter Wahrscheinlichkeit um eine Einstreuung handelt. Bei dem in Figur 3 dargestellten Verfahren wird dann der nächste Schritt S4 eingeleitet, bei dem eine dritte Überprüfung stattfindet. Wird dagegen im Schritt S3 ein charakteristischer Sprung der Frequenz gemäß Figr 4a nicht erkannt, wird im Schritt S5 überprüft, ob das auszuwertende Signal einen Frequenzverlauf aufweist, wie er in Figur 4b dargestellt ist. Diese sog. Langzeiterkennung im Schritt S5 wird anhand folgender Überlegungen durchgeführt:
Tritt eine Einstreuung auf, ist die Schwankungsbreite nach einer gewissen Zeit sehr schmal, es kann daher das Frequenzband C/D sehr eng gewählt werden, dadurch wird die Wahrscheinlichkeit auf falsche Erkennung bei Einstreuung erniedrigt. Da das Signal erst nach einer gewissen Zeit eingeschwungen ist, kann die Überwachung erst danach aktiviert werden. Dazu wird aus dem Frequenzsignal des Drehzahlfühlers eine zusätzliche, mit einem sog. PT1-Glied gefilterte Frequenz fg abgeleitet. Erst wenn sich f und fg innerhalb der Grenzen C/D befinden, kann über die Langzeiterkennung auf Einstreuung erkannt werden. Bei der Langzeiterkennung wird zusätzlich davon ausgegangen, daß mindestens ein anderes Frequenzsignal einstreuungsfrei ist, d. h. nahe bei fmin liegt oder daß bei einem anderen schon eine Einstreuung erkannt wurde. Weiterhin müßten sich beide Frequenzen f und fg tendenziell nach oben bewegen oder gleichbleiben, da eine fallende Frequenz für eine Einstreuung nicht charakteristisch ist.

Wird im Schritt S5 erkannt, daß die vorstehend beschriebene Langzeiterkennung der Frequenzänderung aufgetreten ist, wird ebenfalls Schritt S4 aktiviert und es findet die dritte Überprüfung statt. Wird dagegen in Schritt S5 die Langzeiterkennung nicht erkannt, wird das Signal als richtig erkannt und dem nachfolgenden Regler zugeführt (S8). Die Einstreuerkennung wird für diesen Zyklus beendet.

In der dritten Prüfung nach Schritt S4 findet eine Plausibilitätsüberprüfung statt, die parallel gemessene andere Signale mitberücksichtigt. Diese anderen Signale sind beispielsweise die Signale der anderen Raddrehzahlfühler (DF2,DFX) mit X=3 oder 4 bei ABS oder ein Signal, das im Zusammenhang mit ABS, ABSR oder FDR ohnehin vorhanden sind.

Ergibt die Plausibilitätüberprüfung nach Schritt S4, z. B. der Vergleich der vier DF-Signale, daß die mittels Langzeiterkennung oder Sprungerkennung vermutete Einstreuung doch keine Einstreuung ist, wird das betreffende Signal als Nutzsignal an den Regler weitergeleitet. Es kann davon ausgegangen werden, daß wenn ein Signal mittels Langzeiterkennung oder Sprungerkennung Einstreuungen erkennen würde und eines der anderen Signale ist weder innerhalb der Grenzen, noch unterhalb des nutzbaren Signalbereiches, so liegt mit größter Sicherheit keine Einstreuung vor. Daraus folgt:

Alle vier Sensoren müssen sich innerhalb der Grenzen oder unterhalb des nutzbaren Signalbereiches befinden, wenn eine Einstreuung vorliegt.

Wenn auf Einstreuung geschlossen wird und das überprüfte Signal im Schritt S4 endgültig als Signal, das durch Einstreuung verursacht ist, erkannt, erfolgt eine Unterdrückung oder Korrektur des Signals nach S7. Wird dagegen im Schritt S4 erkannt, daß es sich um ein plausibles Signal handelt, wird das Signal als richtig erkannt und einem nachfolgenden Regler, beispielsweise ABS-Regler als Eingangsgröße bzw. Istgröße zugeführt. Wird auf Einstreuung erkannt, wird das Signal wie bereits erwähnt, nach S7 behandelt. In diesem Fall wird die Frequenz f mit einer geeigneten Steigung (0-∞) gegen die Frequenz fmin angeglichen oder bei einem Sprung das Signal unterdrückt. Dieses korrigierte Signal wird dann an den Regler weitergeleitet.

Sobald sich das auszuwertende Signal innerhalb des nutzbaren Signalbereiches befindet und nicht innerhalb eines dritten Grenzbandes das größer als das Band A/B bzw. C/D sein muß (Hysterese), wird davon ausgegangen, daß ein reales Signal vorliegt und die Einstreuungserkennung wird zurückgesetzt.

## Patentansprüche

1. Einrichtung zur Erkennung von elektromagnetischen Einstreuungen bei einem System mit wenigstens zwei induktiven Aufnehmern (10), die ein im wesentlichen periodisches Ausgangssignal liefern, mit Signalauswertemitteln (12) zur Auswertung der Signale der Aufnehmer, wobei zur Erkennung der elektromagnetischen Einstreuung geprüft wird, ob die Perioden der auszuwertenden Signale im Bereich der Periodendauer einer erwarteten Einstreuung liegt, **dadurch gekennzeichnet, daß** zutreffendenfalls geprüft wird, ob die ermittelten Signalverläufe wenigstens einen für Einstreuungen typischen Verlauf aufweisen und daß zusätzlich Plausibilitätsüberprüfungen mit wenigstens einem weiteren ermittelten Signal erfolgen und die Einstreuung nur dann erkannt wird, wenn alle untersuchten Bedingungen ein für Einstreuungen typisches Ergebnis liefern.

2. Einrichtung nach Anspruch 1, **dadurch gekennzeichnet, daß** die Signalauswertung mittels eines Mikroprozessors oder als vorgelagertes Modul im Mikroprezessor des Reglers durchgeführt wird, der oder das die erforderlichen Prüfverfahren durchführt.

3. Einrichtung nach Anspruch 1 oder 2, **dadurch gekennzeichnet, daß** bei erkannter Einstreuung das betreffende Signal unterdrückt oder korrigiert wird und somit ein Ersatzsignal gebildet wird, das zur Weiterverarbeitung bereitgestellt wird.

4. Einrichtung nach Anspruch 3, **dadurch gekennzeichnet, daß** die Weiterverarbeitung in einem Regler eines Antiblockierregelsystems, eines Antriebsschlupfregelsystems, eines kombinierten Antiblockier/Antriebschlupfregelsystem oder einer Fahrdynamikregelung oder ähnlichem eingesetzt wird.

5. Einrichtung nach einem der vorhergehenden Ansprüche, **dadurch gekennzeichnet, daß** die Ausgangssignale wenigstens zweier induktiver Aufnehmer auf Einstreuung überprüft werden und die Ergebnisse auf Plausibilität geprüft werden.

6. Einrichtung nach einem der vorhergehenden Ansprüche, **dadurch gekennzeichnet, daß** die Überprüfung ob ein für Einstreuung typischer bzw. charakteristisches Signalverlauf vorliegt anhand einer Untersuchung einer Frequenzänderung des Signales über der Zeit erfolgt.

7. Einrichtung nach einem der vorhergehenden Ansprüche, **dadurch gekennzeichnet, daß** wenigstens zwei für Einstreuung charakteristische Frequenzverläufe untersucht werden, wobei der erste Frequenzverlauf ein Sprung der Frequenz von einer Minimalfrequenz in ein vorgebbares Frequenzband mit den Grenzen A und B ist und der zweite Frequenzverlauf ein langsames schrittweises Ansteigen der Frequenz von einer minimalen Frequenz in ein Frequenzband mit den Grenzen C und D ist.

8. Einrichtung nach Anspruch 7, **dadurch gekennzeichnet, daß** die Grenzen A, B, C und D anhand empirischer Messungen festgelegt werden.

9. Einrichtung nach Anspruch 8, **dadurch gekennzeichnet, daß** das Frequenzband zwischen den Grenzen A und B größer ist als das Frequenzband zwischen den Grenzen C und D.

10. Einrichtung nach Anspruch B oder 9, **dadurch gekennzeichnet, daß** der Frequenzverlauf gefiltert wird und das schrittweise Eintreten in das Erkennungsband C/D erst dann erfolgt, wenn auch die gefilterte Frequenz das betreffende Erkennungsband erreicht.

11. Einrichtung nach einem der vorhergehenden Ansprüche, **dadurch gekennzeichnet, daß** für das Rücksetzen einer Einstreuung ein Frequenzband verwendet wird, dessen Grenzen die Grenzen A,B,C, und D beinhalten, damit eine Hysterese entsteht, um "nervöses" Erkennen und Rücksetzen zu vermeiden.

## Claims

1. Device for detecting electromagnetic interference in a system having at least two inductive pickups (10) which supply an essentially periodic output signal, having signal evaluation means (12) for evaluating the signals of the pickups, in which case, in order to detect the electromagnetic interference, it is tested whether the periods of the signals to be evaluated lie in the region of the period length of expected interference, **characterized in that**, if appropriate, it is tested whether the signal profiles which are determined have at least a profile which is typical of interference, and **in that** in addition plausibility checks are made with at least one further signal which is determined, and the interference is detected only if all the conditions investigated supply a result which is typical of interference.

2. Device according to Claim 1, **characterized in that** the signal evaluation is carried out by means of a microprocessor or as a module mounted upstream in the microprocessor of the regulator, which microprocessor or module carries out the necessary test procedures.

3. Device according to Claim 1 or 2, **characterized in that**, when interference is detected, the respective signal is suppressed or corrected and an equivalent signal, which is made available for further processing, is thus formed.

4. Device according to Claim 3, **characterized in that** the further processing is used in a regulator of an anti-lock braking control system, of a traction control system, of a combined anti-lock braking/traction control system or a vehicle dynamics controller or the like.

5. Device according to one of the preceding claims, **characterized in that** the output signals of at least two inductive pickups are checked for interference and the results are tested for plausibility.

6. Device according to one of the preceding claims, **characterized in that** the check to determine whether a signal profile which is typical or characteristic of interference is present is carried out by investigating a change in frequency in the signal over time.

7. Device according to one of the preceding claims, **characterized in that** at least two frequency profiles which are characteristic of interference are investigated, the first frequency profile being a jump in the frequency from a minimum frequency to a predefinable frequency band with the limits A and B, and the second frequency profile being a slow, incremental rise in the frequency from a minimum frequency to a frequency band with the limits C and D.

8. Device according to Claim 7, **characterized in that** the limits A, B, C and D are defined by means of empirical measurements.

9. Device according to Claim 8, **characterized in that** the frequency band between the limits A and B is greater than the frequency band between the limits C and D.

10. Device according to Claim 8 or 9, **characterized in that** the frequency profile is filtered and the incremental adjustment to the detection band C/D takes place only if the filtered frequency also reaches the respective detection band.

11. Device according to one of the preceding claims, **characterized in that** a frequency band whose limits include the limits A, B, C and D is used to reset interference so that hysteresis occurs in order to avoid "jumpy" detection and resetting.

## Revendications

1. Installation de détection de perturbations électromagnétiques induites dans un système ayant au moins deux capteurs inductifs (10) fournissant un signal de sortie essentiellement périodique,
des moyens de traitement de signal (12) pour exploiter les signaux des capteurs (1),
et pour reconnaître la perturbation électromagnétique induite on vérifie si la période des signaux à exploiter se situe dans une plage de périodes d'une perturbation induite prévisible,
**caractérisée en ce qu'**
on vérifie le cas échéant si les courbes des signaux obtenus ont une forme caractéristique d'une perturbation induite et
en plus on effectue des contrôles de plausibilité avec au moins un autre signal obtenu et
on estime qu'il y a une perturbation induite seulement si toutes les conditions examinées fournissent un résultat caractéristique d'une perturbation induite.

2. Installation selon la revendication 1,
**caractérisée en ce que**
le traitement du signal est fait par un microprocesseur ou comme module en amont du microprocesseur du régulateur, qui effectue le ou les procédés de contrôle nécessaires.

3. Installation selon l'une quelconque des revendications 1 ou 2,
**caractérisée en ce qu'**
en cas de perturbation induite, reconnue, on élimine ou on corrige le signal concerné et on forme ainsi un signal de remplacement fourni pour la suite du traitement.

4. Installation selon la revendication 3,
**caractérisée en ce que**
la suite du traitement se fait dans un régulateur d'un système antiblocage, d'un système de régulation antipatinage, d'un système combiné antiblocage/antipatinage ou d'un système de régulation de la dynamique de roulement ou un système analogue.

5. Installation selon l'une quelconque des revendications précédentes,
**caractérisée en ce qu'**
on vérifie les signaux de sortie d'au moins deux capteurs inductifs pour déterminer les perturbations induites et on contrôle la plausibilité des résultats.

6. Installation selon l'une quelconque des revendications précédentes,
**caractérisée en ce qu'**
on vérifie si la courbe du signal est caractéristique ou typique d'une perturbation induite en contrôlant une variation de fréquence du signal en fonction du temps.

7. Installation selon l'une quelconque des revendications précédentes,
**caractérisée en ce qu'**
on examine au moins deux courbes de fréquences caractéristiques d'une perturbation induite, la première courbe de fréquence correspondant à un saut de fréquence d'une fréquence minimale dans une bande de fréquence prédéterminée avec des limites A et B et la seconde courbe de fréquence correspond à une croissance pas à pas, lente, de la fréquence à partir d'une fréquence minimale dans une bande de fréquence avec pour limite C et D.

8. Installation selon la revendication 7,
**caractérisée en ce que**
les limites A, B, C et D sont fixées empiriquement à l'aide de mesures.

9. Installation selon la revendication 8,
**caractérisée en ce que**
la bande de fréquence entre les limites A et B est plus grande que la bande de fréquence entre les limites C et D.

10. Installation selon l'une quelconque des revendications 8 ou 9,
**caractérisée en ce qu'**
on filtre la courbe de fréquence et on arrive pas à pas dans la bande de détection C/D seulement si la fréquence filtrée atteint la bande de détection concernée.

11. Installation selon l'une quelconque des revendications précédentes,
**caractérisée en ce que**
pour la remise à l'état initial d'une perturbation induite, on utilise une bande de fréquence dont les limites contiennent les limites A, B, C et D pour avoir une hystérésis évitant une détection « nerveuse » et une remise à l'état initial.
